# EUROPÄISCHE PATENTSCHRIFT

(11) **EP 2 293 085 B1**
(45) Veröffentlichungstag und Bekanntmachung des Hinweises auf die Patenterteilung: **01.01.2014**
(21) Anmeldenummer: 10009267.5
(22) Anmeldetag: 07.09.2010
(51) Int. Cl.: G01R 1/04, G01R 15/12, G01R 19/25, G01D 11/24, H01M 2/10, H05K 5/00, H05K 5/02

(54) **Messinstrument**
Measuring device
Appareil de mesure

(30) Priorität: 07.09.2009 DE 202009012059 U
(43) Veröffentlichungstag der Anmeldung: 09.03.2011
(73) Patentinhaber: Conrad Electronic SE, 92240 Hirschau (DE)
(72) Erfinder: Lang, Erhard, 92546 Schmidgaden (DE)
(74) Vertreter: Stippl, Hubert

(56) Entgegenhaltungen:
- EP-A1- 0 366 507
- EP-A2- 0 866 509
- DE-C1- 4 438 239
- DE-U1-202004 017 714

## Beschreibung

Die Erfindung betrifft ein Messinstrument gemäß dem Oberbegriff des Anspruchs 1.

Messinstrumente, wie beispielsweise digitale Multimeter, lassen sich über Messschnüre mit einem Messobjekt verbinden, um die Werte bestimmter Parameter zu bestimmen. Zum Betrieb benötigen derartige Messinstrumente eine Batterie, die von Zeit zu Zeit ausgetauscht werden muss. Gelegentlich ist auch eine Sicherung vorgesehen, die bei Überlastung des Instrumentes durchschmilzt und dann ebenfalls ausgewechselt werden muss. Solche auswechselbaren Elemente sind im Messgerät üblicherweise jeweils in einem Fach untergebracht, das mit einem Deckel verschließbar ist. Stellt sich im Verlauf einer Messung die Notwendigkeit heraus, Batterie oder Sicherung auszuwechseln, dann sollte das Messinstrument zuvor aus Sicherheitsgründen vom Messobjekt abgetrennt werden. Wird dies vergessen und steht das Messinstrument unter Spannung, dann kann man beim Auswechselvorgang möglicherweise einen elektrischen Schlag bekommen.

Die DE 44 38 239 Cl beschreibt ein batteriebetriebenes Messgerät. Um zu erreichen, dass ein Batteriewechsel nur mit abgezogenen Messleitungen vorgenommen werden kann, ist die Aufnahme für die Batterien von einem an das Gerätegehäuse abnehmbar anbaubaren Adaptergehäuse abgedeckt. Sowohl das Gerätegehäuse als auch das Adaptergehäuse besitzen im zusammengebauten Zustand fluchtende Öffnungen, die ein Einstecken sowie ein Abziehen von Messleitungen ermöglichen. Messleitungen können daher nur abgezogen werden, wenn das Adaptergehäuse mit dem Gerätegehäuse verbunden ist.

Aus der EP 0866 509 A2 ist ein Messgerät bekannt, bei dem Öffnungen für ein Anschliessen von Messleitungen im Gerätegehäuse vorgesehen sind, die mit in einer abnehmbaren Batteriefachabdeckung vorgesehenen Öffnungen fluchten. Die Batteriefachabdeckung kann folglich nur entfernt werden, wenn die Messleitungen vorher herausgezogen worden sind.

Der Erfindung liegt die Aufgabe zugrunde, ein Messinstrument zur Verfügung zu stellen, welches die vorgennanten Nachteile vermeidet.

Dise Aufgabe wird durch di im Anspruch 1 angegebenen Merkmale gelöst. Weiterbildungen der Erfindung sind in den Unteransprüchen gekennzeichnet.

Wenn also beispielweise bei einem Multimeter die Batterie oder eine Sicherung ausgetauscht werden soll und dazu das Gerät zumindest teilweise geöffnet werden muss, wird durch die Erfindung verhindert, dass es über seine Messleitungen noch an spannungsführenden Teilen des Messobjektes liegt, was zu Stromschlägen führen kann. Hiergegen bietet die Erfindung dadurch Sicherheit, dass ein Zugang zu den Fächern für Batterie bzw. Sicherung nur dann von einem beweglichen Sperrglied freigegeben wird, wenn keine Messleitung mehr mit dem Messinstrument verbunden ist. Dieses Sperrglied gibt erfindungsgemäß entweder nur die Anschlussbuchsen des Messinstrumentes für die Messleitungen, nicht aber die Abdeckungen für das Batteriefach bzw. das Sicherungsfach frei bzw. umgekehrt.

Zweckmäßigerweise ist die zweite Position des Sperrglieds, also die Position, bei der die Messbuchse gesperrt ist, mittels eines Kraftspeichers, beispielsweise eines Federspeichers, vorgespannt.

Gemäß einer Ausgestaltung der vorliegenden Erfindung erfolgt die Sperrung der jeweiligen Messbuchse durch ein Sperrelement des Sperrglieds, welches in der Sperrposition in den ringartigen Aufsteckraum der Messbuchse eingreift. Das Sperrelement erstreckt sich hierbei vorzugsweise bis an das Ende der Messbuchse oder sogar über dieses hinaus, damit gewährleistet ist, dass keinerlei Kontakt mit einem Stecker bei gesperrtem Messinstrument möglich ist.

Zweckmäßigerweise ist das Sperrglied als Wippe ausgebildet und führt demzufolge eine Verschwenkbewegung durch. Zudem weist das Abdeckteil eine erste Rampe auf, die mit einem ersten Anschlag des Sperrglieds zusammenwirkt. Hierbei bewegt sich das Sperrelement von der Messbuchse weg und gibt den Einsteckraum hierdurch frei. Zudem weist das Abdeckteil eine zweite Rampe auf, die mit einem zweiten Anschlag des Sperrglieds zusammenwirkt. Die zweite Rampe hemmt die Bewegung des Abdeckteils bei aufgestecktem Stecker. Hierdurch wird verhindert, dass sich das Abdeckteil bei aufgestecktem Stecker öffnen lässt. Wird der Stecker allerdings abgezogen, bewirkt der Kraftspeicher des Sperrglieds eine Sperrung des Aufsteckraums der Messbuchse durch Verschwenkbewegung des Sperrglieds.

Gemäß einer zweckmäßigen Ausgestaltung ist das Sperrglied im Inneren des Gehäuses des Messinstruments zweiseitig gelagert, und zwar beispielsweise durch seitlich angeformte Gelenkzapfen. Zweckmäßigerweise befinden sich diese, in Längsrichtung des Sperrglieds betrachtet, etwa im Bereich des Gelenkzapfens.

Das Sperrglied umfasst vorzugsweise eine Mehrzahl von Sperrelementen, wobei jedem Sperrelement eine eigene Messbuchse zugeordnet ist. Hierdurch wird sichergestellt, dass das Abdeckteil auch dann nicht geöffnet werden kann, wenn beispielsweise nur noch ein Stecker auf einer Messbuchse sich befindet.

Fertigungstechnisch günstig ist es, wenn das Sperrglied einstückig, beispielsweise als Spritzgussteil, ausgebildet ist.

Das Sperrglied ermöglicht es, dass sich das Abdeckteil auf der den Messbuchsen gegenüberliegenden Seite des Messinstruments befindet. Daraus resultiert der Vorteil, dass auf Seiten der Messbuchsen großflächige Displays angeordnet werden können.

Zudem kann ein konstruktiv einfaches, längsverschiebliches Abdeckteil zum Einsatz kommen.

Die Erfindung sei nun anhand eines in den beiliegenden Figuren veranschaulichten Ausführungsbeispiels im Einzelnen erläutert.

Es zeigen:
- Fig. 1: eine stark vereinfachte schematische Darstellungsweise der Funktion des Sperrglieds in Freigabeposition (Fig. 1A) sowie in Sperrposition (Fig. 1B);
- Fig. 2: eine stark vereinfachte schematische Darstellungsweise des Sperrglieds bei aufgestecktem Stecker einer Messleitung bei geschlossenem Abdeckteil (Fig. 2A) sowie beim Versuch, das Abdeckteil bei einem aufgesteckten Stecker zu öffnen (Fig. 2B);
- Fig. 3: eine stark vereinfachte schematische Darstellungsweise des Sperrglieds (Fig. 3A) sowie des Abdeckteils (Fig. 3B); sowie
- Fig. 4: eine perspektivische Darstellung des Messinstruments gemäß der vorliegenden Erfindung mit Blickrichtung der Vorderseite schräg von oben (Fig. 4A) sowie der Rückseite schräg von oben (Fig. 4B).

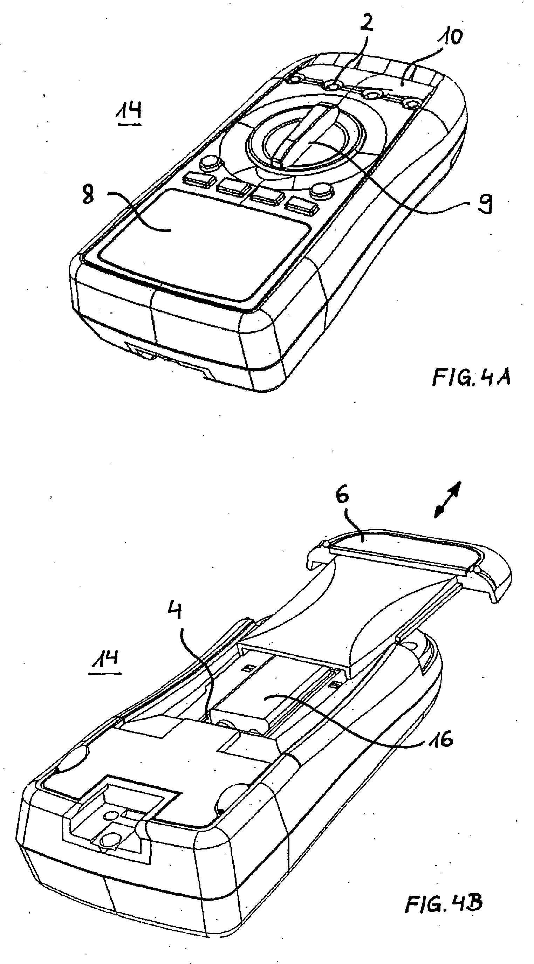

Bezugszeichen 14 in Fig. 4A bezeichnet das erfindungsgemäße Messinstrument in seiner Gesamtheit. Es umfasst ein ein- oder mehrteiliges Gehäuse 10, ein großflächiges Display 8, einen Drehgriff 9 zum Umschalten des Messbereichs sowie eine Mehrzahl von Messbuchsen 2 zur Aufnahme von Messleitungen, die über entsprechende Stecker in die Messbuchsen eingesteckt werden. Im Bereich der Messbuchsen 2 sind kreisförmige Aussparungen in dem Gehäuse 10 vorgesehen. Zudem können an der Oberseite noch einzelne (in Fig. 4A nicht dargestellte) Tasten vorgesehen sein.

An der Rückseite des Messinstruments 14 befindet sich ein Aufnahmefach 4 für ein austauschbares Bauelement, im vorliegenden Fall beispielsweise für zwei stabförmige Batterien 16. Das Aufnahmefach 4 ist durch das längsverschiebliche Abdeckteil 6 verschließbar.

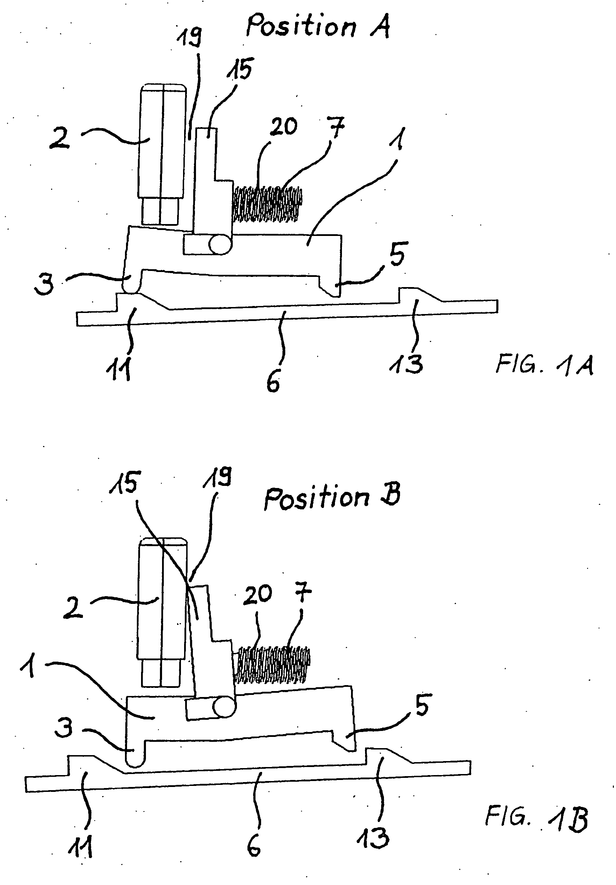

Fig. 1A zeigt die durch die vorliegende Erfindung beanspruchte Sicherung der Messbuchsen 2, von denen in Fig. 1A lediglich eine davon der Übersichtlichkeit halber dargestellt ist. Verkabelungen von der Messbuchse 2 in das Innere des Messinstruments sind aus Übersichtlichkeitsgründen nicht dargestellt. Das erfindungsgemäße Messinstrument umfasst ein Sperrglied 1, welches nach Art einer Wippe verschwenkbar innerhalb des Gehäuses 10 des Messinstruments 14 gelagert ist. Es umfasst ein Querteil, an dessen jeweiligen Ende sich ein erster Anschlag 3 sowie ein zweiter Anschlag 5 befinden.

Erster und zweiter Anschlag 3 bzw. 5 wirken mit einer ersten Rampe 11 bzw. zweiten Rampe 13 des Abdeckteils 6 zusammen. Jede Rampe 11 bzw. 13 verfügt über eine Anlaufschräge. Ebenso verfügt auch der zweite Anschlag 5 über eine Anlaufschräge.

Das Sperrglied 1 wird über eine Feder 7, insbesondere Spiralfeder, mit Druck zur Messbuchse 2 hin beaufschlagt.

Die Fig. 1A zeigt das Sperrglied 1 in der Freigabeposition (Position A), bei der der erste Anschlag 3 mit der ersten Rampe 11 zusammenwirkt derart, dass das Sperrglied 1 leicht im Uhrzeigersinn verschwenkt positioniert ist. Das an der Oberseite mit seiner Basis etwa in der Höhe des Schwenkpunkts liegende Sperrelement 15 ist zur Messbuchse 2 beabstandet und hierdurch ein ringförmiger Aufsteckraum 19 freigegeben. Die in Fig. 1A dargestellte Freigabeposition entspricht dem Zustand, bei dem das Aufnahmefach 4 mittels des Abdeckteils 6 verschlossen ist. In diesem Zustand kann ein Stecker einer Messleitung in die Messbuchse 2 eingesteckt werden.

Wird, wie in Fig. 1B dargestellt, das Abdeckteil 6 nach links verschoben und damit das Aufnahmefach 4 geöffnet, bewegt sich der erste Anschlag 3 des Sperrglieds 1 bedingt durch die Kraft der Feder 7 aufgrund einer Verschwenkbewegung nach unten. Gleichzeitig schwenkt das Sperrelement 15 leicht in Fig. 1B nach links, also in den Aufsteckraum 19 der Messbuchse 2 hinein. In dieser Position B, oder auch Sperrposition genannt, kann somit bei geöffnetem Aufnahmefach, wie es in Fig. 4B dargestellt ist, ein Stecker auf die Messbuchse 2 nicht aufgesteckt werden.

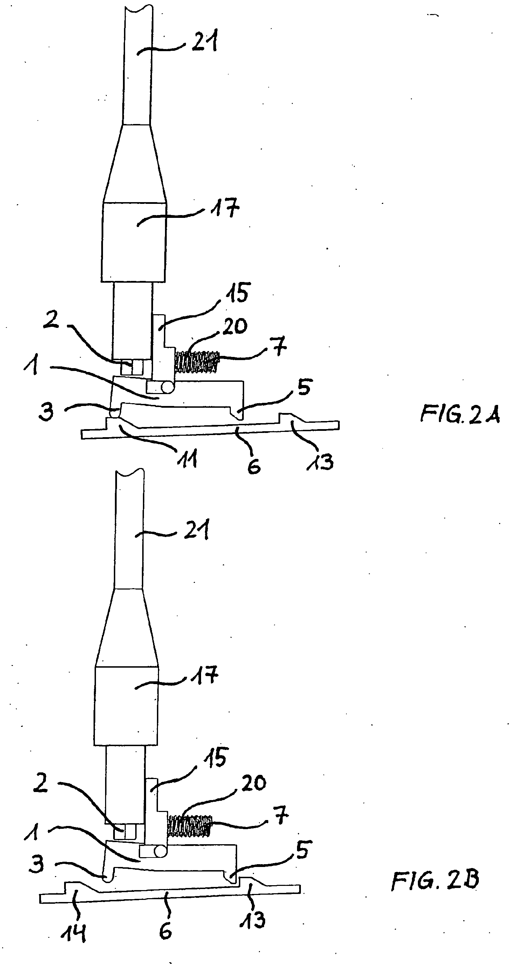

Die Figuren 2A sowie 2B zeigen die Wirksamkeit der Sicherungseinrichtung bei aufgestecktem Stecker 17 einer Messleitung 21. Im Zustand der Fig. 2A ist das Abdeckteil 6 verschlossen. Der Stecker 17 mit seiner Messleitung 21 kann in diesem Zustand abgezogen werden, da das Sperrelement 15 aufgrund des Zusammenwirkens der ersten Rampe 11 mit dem ersten Anschlag 3 des Sperrglieds 1 nicht in den Aufsteckraum 19 hineinragt.

Wird nun in diesem Zustand versucht, das Abdeckteil 6 durch lineare Bewegung zu verschieben, um das Aufnahmefach 4 des Messinstruments 14 zu öffnen, schlägt die zweite Rampe 13 mit ihrer senkrecht stehenden Anschlagfläche an die ebenfalls senkrecht stehende Stirnseite oder ein entsprechender Anschlag des Sperrglieds 1 an und verhindert eine weitere Öffnungsbewegung des Abdeckteils 6. Daraus resultiert die Tatsache, dass in diesem Zustand weder eine Batterie aus dem Aufnahmefach 4 herausgenommen noch eingesetzt werden kann. Dies geht erst, wenn der Stecker 17 von der Messbuchse 2 abgezogen wird.

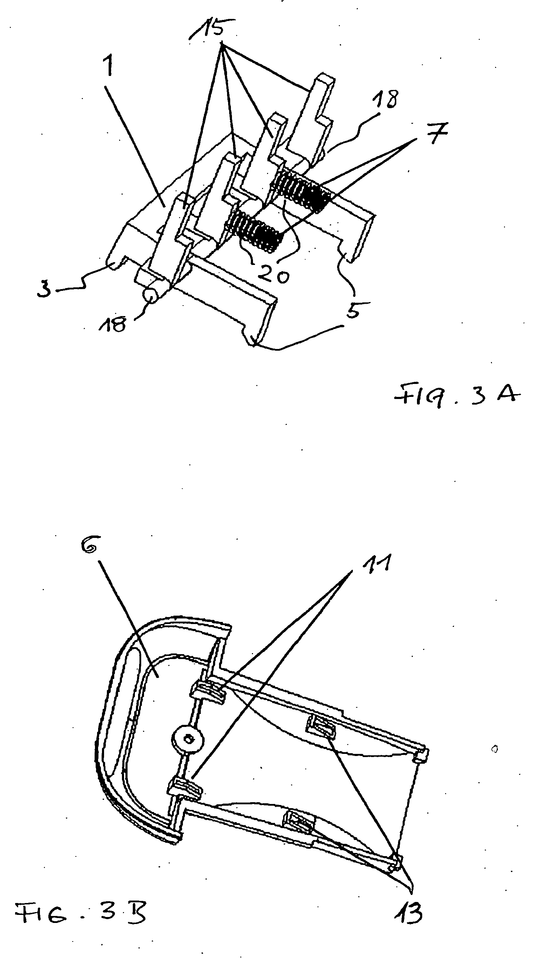

Gemäß Fig. 3A ist das Sperrglied 1 mit einer Mehrzahl von Sperrelementen 15 ausgestattet, wobei jedes Sperrelement 15 für eine zugehörige Messbuchse 2 vorgesehen ist. Das gesamte Sperrglied 1 ist über beidseitig angeordnete Gelenkzapfen 18 innerhalb des Gehäuses 10 des Messinstruments 14 verschwenkbar gelagert. Zudem sind zwei jeweils an einer Aufnahme 20 angeordnete Federn 7, insbesondere Spiralfedern, zur Gewährleistung eines Kraftspeichers und damit zur Vorspannung des Sperrglieds 1 vorgesehen. Der erste Anschlag 3 sowie zweite Anschlag 5 ist jeweils beidseitig des Sperrglieds 1 angeformt und steht gemäß Fig. 3B mit entsprechend angeordneten und ausgebildeten ersten und zweiten Rampen 11 bzw. 13 in Verbindung.

Das Sperrglied 1 ist zweckmäßigerweise als einstückiges Teil, vorzugsweise als Kunststoffspritzgussteil, ausgebildet. Bei der Montage braucht das Sperrglied 1 lediglich in die jeweils vorgesehene Lagerausnehmung am Gehäuse 10 über dessen Gelenkzapfen 18 eingesetzt werden.

Die Konstruktion gewährleistet einerseits eine besondere Sicherheit bei der Anwendung von Messinstrumenten, andererseits ist die Konstruktion mit einfachen konstruktiven Mitteln zu realisieren. Die Erfindung stellt daher einen ganz besonderen Beitrag auf dem einschlägigen Gebiet der Technik dar.

### BEZUGSZEICHENLISTE

- 1: Sperrglied
- 2: Messbuchsen
- 3: erster Anschlag
- 4: Aufnahmefach
- 5: zweiter Anschlag
- 6: Abdeckteil
- 7: Feder
- 8: Display
- 9: Drehgriff
- 10: Gehäuse
- 11: erste Rampe
- 12: Öffnungen
- 13: zweite Rampe
- 14: Messinstrument
- 15: Sperrelement
- 16: Batterie
- 17: Stecker
- 18: Gelenkzapfen
- 19: Aufsteckraum
- 20: Aufnahme
- 21: Messleitung

## Patentansprüche

1. Messinstrument mit
einem Gehäuse (8),
mindestens einem Aufnahmefach (4) für ein austauschbares Bauelement, insbesondere Batterie-, Akku- und/oder Sicherung, wobei das Aufnahmefach (4) mittels eines Abdeckteils (6) verschließbar ist,
mindestens einer Messbuchse (2) zur Verbindung des Messinstruments mit einem Messobjekt über eine Messleitung (21),
**dadurch gekennzeichnet, dass**
ein bewegliches Sperrglied (1) vorgesehen ist,
die Beweglichkeit des Sperrglieds (1) dergestalt festgelegt ist, dass das Sperrglied (1) in einer ersten Position A die Messbuchse (2) freigibt sowie in einer zweiten Position B die Messbuchse (2) sperrt und
die Bewegung des Sperrglieds (1) von der ersten Position in die zweite Position durch Bewegung, insbesondere durch Verschieben, des Abdeckteils (6) veranlasst wird.

2. Messinstrument nach Anspruch 1,
**dadurch gekennzeichnet, dass**
die zweite Position des Sperrglieds (1) mittels eines Kraftspeichers, insbesondere eines Federspeichers, vorgespannt ist.

3. Messinstrument nach Anspruch 1 oder 2,
**dadurch gekennzeichnet, dass**
das Sperrglied (1) mindestens ein Sperrelement (15) aufweist, welches in der zweiten Position in den Aufsteckraum (19) eingreift und hierdurch das Aufstecken eines Steckers (17) auf die Messbuchse (2) verhindert.

4. Messinstrument nach Anspruch 3,
**dadurch gekennzeichnet, dass**
das Sperrglied (1) als Wippe ausgebildet ist, indem das Sperrglied (1) zur Gewährleistung der ersten bzw. zweiten Position das Sperrelement (15) eine Verschwenkbewegung ausführt,
das Abdeckteil (6) eine erste Rampe (11) aufweist, die mit einem ersten Anschlag (3) des Sperrglieds (1) zusammenwirkt,
das Abdeckteil eine zweite Rampe (13) aufweist, die mit einem zweiten Anschlag (5) des Sperrglieds (1) zusammenwirkt und
die zweite Rampe (13) bei aufgestecktem Stecker (17) die Bewegung des Abdeckteils (6) hemmt.

5. Messinstrument nach Anspruch 4,
**dadurch gekennzeichnet, dass**
das Sperrglied (1) an jeder Seite desselben einen Gelenkzapfen (18) aufweist und sich das Sperrelement (15), in Längsrichtung des Sperrglieds (1) betrachtet, im Bereich des Gelenkzapfens (18) befindet.

6. Messinstrument nach einem der Ansprüche 3 bis 5,
**dadurch gekennzeichnet, dass**
das Sperrglied (1) eine Mehrzahl von Sperrelementen (15) umfasst, wobei jedes Sperrelement (15) einer Messbuchse (2) zugeordnet ist.

7. Messinstrument nach einem der vorhergehenden Ansprüche,
**dadurch gekennzeichnet, dass**
das Sperrglied (1) einstückig ausgebildet ist.

8. Messinstrument nach einem der vorhergehenden Ansprüche,
**dadurch gekennzeichnet, dass**
sich die Messbuchse (2) auf der dem Abdeckteil (6) gegenüberliegenden Seite des Messinstruments befindet.

9. Messinstrument nach einem der vorhergehenden Ansprüche,
**dadurch gekennzeichnet, dass**
das Abdeckteil (6) zum Öffnen bzw. Verschließen des Aufnahmefachs (4) nach Art eines Schlittens längsverschieblich ist.

10. Messinstrument nach einem der vorhergehenden Ansprüche,
**dadurch gekennzeichnet, dass**
als Kraftspeicher mindestens, vorzugsweise eine Mehrzahl von Federn (7) vorgesehen sind, die mittels einer Aufnahme (20) am Sperrglied (1) lagefixiert sind.

## Claims

1. Measuring instrument comprising
a housing (8),
at least one holding compartment (4) for a replaceable component, in particular a battery, rechargeable battery and/or fuse, where the holding compartment (4) can be closed by means of a covering part (6),
at least one measuring socket (2) to connect the measuring instrument to an object to be measured via a measuring lead (21),
**characterized in that**
a movable locking unit (1) is provided,
the ability of the locking unit (1) to move is fixed in such a way that, in a first position A, the locking unit (1) releases the measuring socket (2) and, in a second position B, locks the measuring socket (2), and
the movement of the locking unit (1) from the first position into the second position is caused by moving, in particular by displacing, the covering part (6).

2. Measuring instrument according to Claim 1,
**characterized in that**
the second position of the locking unit (1) is preloaded by means of an energy store, in particular a spring store.

3. Measuring instrument according to Claim 1 or 2,
**characterized in that**
the locking unit (1) has at least one locking element (15) which, in the second position, engages in the plug-in space (19) and in this way prevents a plug (17) being plugged onto the measuring socket (2).

4. Measuring instrument according to Claim 3,
**characterized in that**
the locking unit (1) is formed as a rocker, **in that** the locking unit (1) executes a pivoting movement in order to ensure the first or second position of the locking element (15),
the covering part (6) has a first ramp (11), which interacts with a first stop (3) belonging to the locking unit (1),
the covering part has a second ramp (13), which interacts with a second stop (5) belonging to the locking unit (1), and
the second ramp (13) inhibits the movement of the covering part (6) when the plug (17) is plugged on.

5. Measuring instrument according to Claim 4,
**characterized in that**
the locking unit (1) has a hinged pin (18) on each side of the same, and the locking element (15), viewed in the longitudinal direction of the locking unit (1), is located in the area of the hinged pin (18).

6. Measuring instrument according to one of Claims 3 to 5,
**characterized in that**
the locking unit (1) comprises a plurality of locking elements (15), each locking element (15) being assigned to a measuring socket (2).

7. Measuring instrument according to one of the preceding claims,
**characterized in that**
the locking unit (1) is formed in one piece.

8. Measuring instrument according to one of the preceding claims,
**characterized in that**
the measuring socket (2) is located on the side of the measuring instrument opposite to the covering part (6).

9. Measuring instrument according to one of the preceding claims,
**characterized in that**
the covering part (6) can be displaced longitudinally in the manner of a slider in order to open and close the holding compartment (4).

10. Measuring instrument according to one of the preceding claims,
**characterized in that**
the energy store provided is at least one spring, preferably a plurality of springs (7), which are fixed in position on the locking unit (1) by means of a holder (20).

## Revendications

1. Instrument de mesure comprenant
un boîtier (8),
au moins un compartiment de réception (4) pour un composant remplaçable, en particulier une batterie, un accumulateur et/ou une sécurité, le compartiment de réception (4) pouvant être fermé au moyen d'une partie de recouvrement (6),
au moins une douille de mesure (2) destinée à connecter l'instrument de mesure à un objet à mesurer par le biais d'une ligne de mesure (21), **caractérisé en ce qu'**
un organe de verrouillage mobile (1) est prévu,
la mobilité de l'organe de verrouillage (1) est déterminée de telle sorte que l'organe de verrouillage (1) libère la douille de mesure (2) dans une première position A et bloque la douille de mesure (2) dans une deuxième position B et
le mouvement de l'organe de verrouillage (1) de la première position dans la deuxième position est assuré par déplacement, en particulier coulissement, de la partie de recouvrement (6).

2. Instrument de mesure selon la revendication 1,
**caractérisé en ce que**
la deuxième position de l'organe de verrouillage (1) est précontrainte au moyen d'un accumulateur de force, en particulier d'un accumulateur à ressort.

3. Instrument de mesure selon la revendication 1 ou 2,
**caractérisé en ce que**
l'organe de verrouillage (1) présente au moins un élément de verrouillage (15) qui vient en prise dans l'espace d'enfichage (19) dans la deuxième position et qui empêche de ce fait l'enfichage d'une fiche (17) sur la douille de mesure (2).

4. Instrument de mesure selon la revendication 3,
**caractérisé en ce que**
l'organe de verrouillage (1) est réalisé sous forme de bascule, l'organe de verrouillage (1) effectuant un mouvement de pivotement pour assurer la première ou la deuxième position de l'élément de verrouillage (15),
la partie de recouvrement (6) présente une première rampe (11) qui coopère avec une première butée (3) de l'organe de verrouillage (1),
la partie de recouvrement présente une deuxième rampe (13), qui coopère avec une deuxième butée (5) de l'organe de verrouillage (1) et
la deuxième rampe (13), lorsque la fiche (17) est enfichée, empêche le mouvement de la partie de recouvrement (6).

5. Instrument de mesure selon la revendication 4,
**caractérisé en ce que**
l'organe de verrouillage (1) présente, sur chaque côté, un pivot d'articulation (18), et l'élément de verrouillage (15), considéré dans la direction longitudinale de l'organe de verrouillage (1), se situe dans la région du pivot d'articulation (18).

6. Instrument de mesure selon l'une quelconque des revendications 3 à 5,
**caractérisé en ce que**
l'organe de verrouillage (1) présente une pluralité d'éléments de verrouillage (15), chaque élément de verrouillage (15) étant associé à une douille de mesure (2).

7. Instrument de mesure selon l'une quelconque des revendications précédentes,
**caractérisé en ce que**
l'organe de verrouillage (1) est réalisé d'une seule pièce.

8. Instrument de mesure selon l'une quelconque des revendications précédentes,
**caractérisé en ce que**
la douille de mesure (2) se trouve sur le côté de l'instrument de mesure opposé à la partie de recouvrement (6).

9. Instrument de mesure selon l'une quelconque des revendications précédentes,
**caractérisé en ce que**
la partie de recouvrement (6) est déplaçable longitudinalement à la manière d'un chariot pour ouvrir ou fermer le compartiment de réception (4).

10. Instrument de mesure selon l'une quelconque des revendications précédentes,
**caractérisé en ce**
**qu'**au moins un, de préférence une pluralité de ressorts (7) sont prévus en tant qu'accumulateur de force, lesquels ressort sont fixés en position au moyen d'un logement (20) sur l'organe de verrouillage (1).
